# EUROPEAN PATENT SPECIFICATION

(11) **EP 2 933 923 B1**
(45) Date of publication and mention of the grant of the patent: **06.12.2017**
(21) Application number: 15150905.6
(22) Date of filing: 13.01.2015
(51) Int. Cl.: G05F 3/26, H03K 19/013, H03K 19/017, H03K 3/012, H03K 3/013, H04L 25/02

(54) **Interface circuit**
Schnittstellenschaltung
Circuit d'interface

(30) Priority: 15.04.2014 KR 20140044832
(43) Date of publication of application: 21.10.2015
(73) Proprietor: Samsung Display Co., Ltd., Gyeonggi-do (KR)
(72) Inventor: Kim, Do-Ik, Gyeonggi-do (KR)
(74) Representative: Mounteney, Simon James

(56) References cited:
- US-A- 4 498 021
- US-A- 4 691 128
- US-A- 5 455 523
- US-A1- 2006 244 488
- US-B2- 6 992 501

## Description

### BACKGROUND OF THE INVENTION

### Field of the Invention

The present invention relates to an interface circuit, and particularly to an interface circuit for minimizing the inflow of noise.

### Description of the Related Art

As a scheme for connecting a microprocessor and other peripheral devices, generally, an address/data bus scheme is used. However, in this scheme, since the use of many pins is required for each device, there are difficulties in reducing the size of the PCB.

In order to solve these difficulties, an inter-integrated circuit (I2C) has been proposed in the 1980s, and only two bus lines are necessary for data transmission using a serial interface for short distance communication. By using only two I/O pins, it is possible to transmit and receive data at a speed of up to 400 kb/s. Further, since it supports a multi-point scheme rather than a point-to-point scheme, devices can be continuously connected to the I2C bus. Since it is required for communication serial interfaces to transmit, receive, store and retrieve an increasingly large amount of data, the interfaces should be able to operate at a high speed, cause minimum interferences (noise) and tolerate interferences. Further, the interfaces should be able to consume less power and occupy a minimum area on the IC. In a conventional I2C interface circuit, a signal of a high level is applied to a transmission line between interface circuits through a pull-up resistor, and an RC delay occurs due to the pull-up resistor and the parasitic capacitance of the transmission line. As the length of the transmission line is longer, a larger amount of RC delay occurs, which causes a decrease in the transmission rate of data. Further, in the case where the output of the I2C is of a high level, noise is easily introduced by the impedance of the pull-up resistor.

US4498021 discloses a booster circuit for transmitting digital signals. For voltage on a digital signal line whose load capacitance is comparatively large as in a bus line of a CMOS integrated circuit, a detection is made that said voltages enter into a specified voltage range between the ground voltage and the power supply voltage, then based on such detection the voltage on said signal line is raised up or pulled down rapidly by a current injection means or a current ejection means, respectively, thereby the signal propagation delay is reduced.

### SUMMARY OF THE INVENTION

Aspects of the present invention seek to provide an interface circuit capable of improving transmission rate and transmission distance by minimizing the inflow of noise as claimed in apparatus claim 1.

Aspects of the present invention also seek to provide an interface circuit capable of minimizing power consumption to prevent the inflow of noise.

However, aspects of the present invention are not restricted to the ones set forth herein. The above and other aspects of the present invention will become more apparent to one of ordinary skill in the art to which the present invention pertains by referencing the detailed description of the present invention given below.

According to an aspect of the present invention, there is provided an interface circuit comprising a first integrated circuit to transmit or receive data, a second integrated circuit
connected to the first integrated circuit by a transmission line to transmit or receive data, and a constant current generating circuit connected to the transmission line to output a current of a constant magnitude to the transmission line, wherein the constant current generating circuit adjusts the amount of current outputted to the transmission line by sensing a voltage level of the transmission line.

The constant current generating circuit may comprise a voltage sensing unit which senses a voltage of the transmission line to generate a first current corresponding to the voltage, and a constant current generation unit which outputs a current corresponding to the first current.

The constant current generation unit may comprise a plurality of transistors, wherein the constant current generation unit may comprise a current mirror to output a second current corresponding to the first current.

The voltage sensing unit may comprise at least one sensing transistor, wherein the sensing transistor may be turned on in response to the voltage of the transmission line and generates the first current corresponding to the voltage of the transmission line.

Each of the sensing transistor and the transistors may be formed of a bipolar transistor.

Each of the sensing transistor and the transistors may be formed of a field effect transistor.

The voltage sensing unit may comprise a comparator and a first diode, wherein the comparator may compare the voltage of the transmission line with a reference voltage to output a predetermined voltage.

Each of the transistors may be formed of a bipolar transistor.

Each of the transistors may be formed of a field effect transistor.

The voltage sensing unit may comprise a differential amplifier and a plurality of diodes, wherein the differential amplifier may output a voltage corresponding to the voltage of the transmission line.

Each of the transistors may be formed of a bipolar transistor.

Each of the transistors may be formed of a field effect transistor.

According to another aspect of the present invention, there is provided an interface circuit comprising a first integrated circuit to transmit or receive data, a second integrated circuit connected to the first integrated circuit by a transmission line to transmit or receive data, and a plurality of constant current generating circuits connected to the transmission line to output a current of a constant magnitude to the transmission line, wherein each of the constant current generating circuits adjusts the amount of current outputted to the transmission line by sensing a voltage level of the transmission line.

Each of the constant current generating circuits may comprise a voltage sensing unit which senses a voltage of the transmission line to generate a first current corresponding to the voltage, and a constant current generation unit which outputs a current corresponding to the first current, wherein the constant current generation unit may comprise a plurality of transistors and comprises a current mirror to output a second current corresponding to the first current.

The voltage sensing unit may comprise at least one sensing transistor, wherein the sensing transistor may be turned on in response to the voltage of the transmission line and generates the first current corresponding to the voltage of the transmission line.

The voltage sensing unit may comprise a comparator and a first diode, wherein the comparator may compare the voltage of the transmission line with a reference voltage to output a predetermined voltage.

The voltage sensing unit may comprise a differential amplifier and a plurality of diodes, wherein the differential amplifier may output a voltage corresponding to the voltage of the transmission line.

According to still another aspect of the present invention, there is provided an interface circuit comprising a plurality of first integrated circuits to transmit or receive data, a plurality of second integrated circuits connected to each of the first integrated circuits by a transmission line to transmit or receive data, and a constant current generating circuit connected to the transmission line to output a current of a constant magnitude to the transmission line, wherein the constant current generating circuit adjusts the amount of current outputted to the transmission line by sensing a voltage level of the transmission line.

The constant current generating circuit may comprise a voltage sensing unit which senses a voltage of the transmission line to generate a first current corresponding to the voltage, and a constant current generation unit which outputs a current corresponding to the first current, wherein the constant current generation unit may comprise a plurality of transistors and comprises a current mirror to output a second current corresponding to the first current.

The voltage sensing unit may comprise at least one sensing transistor, wherein the sensing transistor may be turned on in response to the voltage of the transmission line and generates the first current corresponding to the voltage of the transmission line.

Embodiments of the present invention provide at least the following effects.

That is, it is possible to provide an interface circuit capable of minimizing the inflow of noise.

Also, it is possible to provide an interface circuit capable of minimizing power consumption by adjusting the amount of current provided to a transmission line.

The effects of the present invention are not limited to the above-described effects and other effects which are not described herein will become apparent to those skilled in the art from the following description.

At least some of the above and other features of the invention are set out in the claims.

### BRIEF DESCRIPTION OF THE DRAWINGS

A more complete appreciation of the invention, and many of the attendant advantages thereof, will be readily apparent as the same becomes better understood by reference to the following detailed description when considered in conjunction with the accompanying drawings, in which like reference symbols indicate the same or similar components, wherein:
FIG. 1 is a block diagram of an interface circuit according to a first embodiment of the present invention;
FIG. 2 is an equivalent circuit diagram of a constant current generating circuit according to the first embodiment of the present invention;
FIG. 3 is an equivalent circuit diagram of the integrated circuit according to the first embodiment of the present invention;
FIG. 4 is a flowchart showing an operation of the interface circuit according to the first embodiment of the present invention;
FIG. 5 is an equivalent circuit diagram of the integrated circuit according to the first embodiment of the present invention;
FIG. 6 is an equivalent circuit diagram of a current mirror according to the first embodiment of the present invention;
FIG. 7 is a circuit diagram illustrating characteristics when the interface circuit according to the first embodiment of the present invention operates at a low level;
FIG. 8 is a circuit diagram illustrating characteristics when the interface circuit according to the first embodiment of the present invention operates at a high level;
FIG. 9 is an equivalent circuit diagram of an interface circuit according to a second embodiment of the present invention;
FIG. 10 is an equivalent circuit diagram of a current mirror according to the second embodiment of the present invention;
FIG. 11 is an equivalent circuit diagram of an interface circuit according to a third embodiment of the present invention;
FIG. 12 is a flowchart showing an operation of the interface circuit according to the third embodiment of the present invention;
FIG. 13 is a circuit diagram showing a comparator according to the third embodiment of the present invention;
FIG. 14 is a graph showing the voltage characteristics of the comparator of FIG. 13.
FIGS. 15 and 16 are circuit diagrams illustrating characteristics when the interface circuit according to the third embodiment of the present invention operates at a high level;
FIG. 17 is an equivalent circuit diagram of an interface circuit according to a fourth embodiment of the present invention;
FIG. 18 is a flowchart showing an operation of the interface circuit according to the fourth embodiment of the present invention;
FIG. 19 is an equivalent circuit diagram of a voltage sensing unit according to the fourth embodiment of the present invention;
FIG. 20 is a graph showing the voltage characteristics of FIG. 19;
FIG. 21 is a circuit diagram showing the characteristics when the interface circuit according to the fourth embodiment of the present invention operates at a high level;
FIG. 22 is an equivalent circuit diagram of an interface circuit according to a fifth embodiment of the present invention; and
FIGS. 23 to 29 are equivalent circuit diagrams of integrated circuits according to some other embodiments of the present invention.

### DETAILED DESCRIPTION

Advantages and features of the present invention and methods of accomplishing the same may be understood more readily by reference to the following detailed description of preferred embodiments and the accompanying drawings. The present invention may, however, be embodied in many different forms and should not be construed as being limited to the embodiments set forth herein. Rather, these embodiments are provided so that this disclosure will be thorough and complete and will fully convey the concept of the invention to those skilled in the art, and the present invention will only be defined by the appended claims. Thus, in some embodiments, well-known structures and devices are not shown in order not to obscure the description of the invention with unnecessary detail. Like numbers refer to like elements throughout. In the drawings, the thickness of layers and regions are exaggerated for clarity.

It will be understood that, when an element or layer is referred to as being "on," or "connected to" another element or layer, it can be directly on or connected to the other element or layer, or intervening elements or layers may be present. In contrast, when an element is referred to as being "directly on" or "directly connected to" another element or layer, there are no intervening elements or layers present. As used herein, the term "and/or" includes any and all combinations of one or more of the associated listed items.

Spatially relative terms, such as "below," "beneath," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures.

Embodiments described herein will be described referring to plan views and/or cross-sectional views by way of ideal schematic views of the invention. Accordingly, the exemplary views may be modified depending on manufacturing technologies and/or tolerances. Therefore, the embodiments of the invention are not limited to those shown in the views, but include modifications in configuration formed on the basis of manufacturing processes. Therefore, regions exemplified in figures have schematic properties, and shapes of regions shown in figures exemplify specific shapes of regions of elements and do not limit aspects of the invention.

It will be noted that "interface circuit" described herein may mean an I2C interface circuit, or an open collector or open drain output circuit.

Hereinafter, embodiments of the present invention will be described with reference to the accompanying drawings.

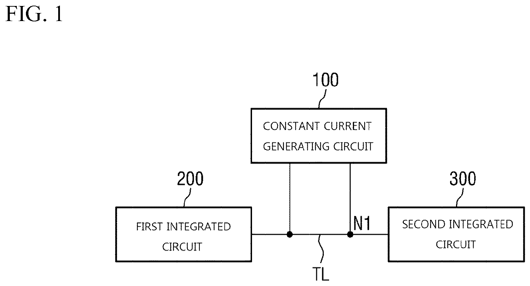

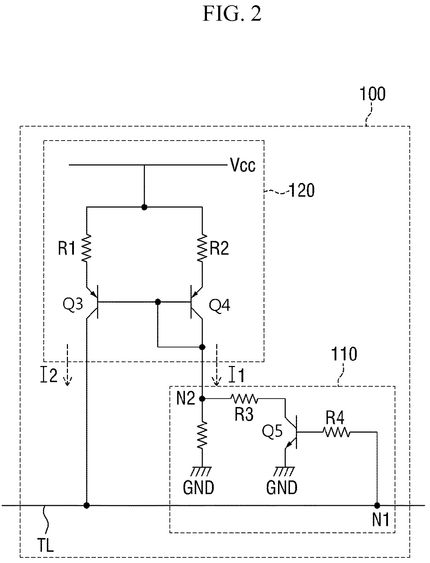

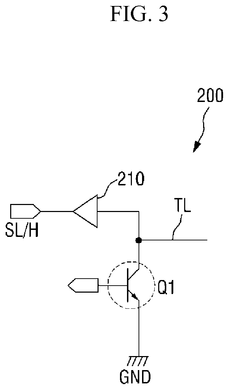

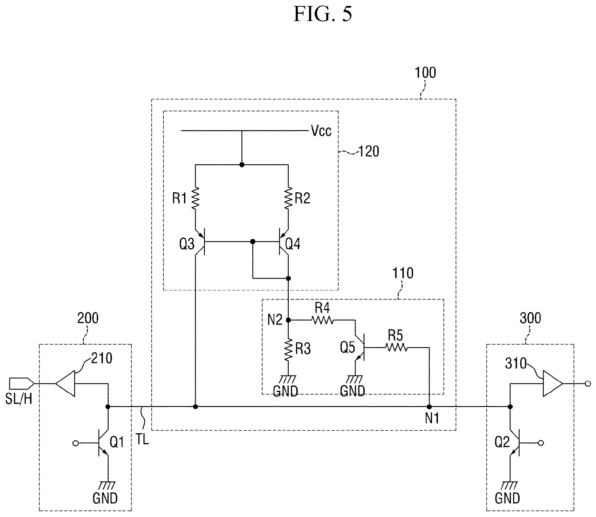

FIG. 1 is a block diagram of an interface circuit according to a first embodiment of the present invention, FIG. 2 is an equivalent circuit diagram of a constant current generating circuit according to the first embodiment of the present invention, FIG. 3 is an equivalent circuit diagram of the integrated circuit according to the first embodiment of the present invention, and FIG. 5 is an equivalent circuit diagram of the integrated circuit according to the first embodiment of the present invention.

Referring to FIG. 1, the interface circuit may include a constant current generating circuit 100, a first integrated circuit 200, and a second integrated circuit 300. The constant current generating circuit 100 may be connected in parallel to a transmission line TL connecting the first integrated circuit 200 to the second integrated circuit 300, and may provide an electric current of a constant magnitude to the transmission line TL. The internal impedance of the transmission line TL increases due to the internal resistance of the transmission line TL, and noise may be easily introduced. Thus, when a signal of a high level is applied to the first integrated circuit 200 or the second integrated circuit 300, the internal impedance of the transmission line TL can be reduced by providing a current to the transmission line TL.

Referring to FIG. 2, the constant current generating circuit 100 may include a voltage sensing unit 110 and a constant current generation unit 120. The voltage sensing unit 110 may generate a first current I1 corresponding to a voltage magnitude of the transmission line TL, and the first current I1 may flow through a first flow path of the constant current generation unit 120. The constant current generation unit 120 may include a current mirror, and may output a second current I2 of the same magnitude as the current flowing through the first flow path. The second current I2 may flow through a second flow path of the constant current generation unit 120, and the second flow path may be electrically connected to the transmission line TL. Although the transmission line TL is shown as a single line, without being limited thereto, the transmission line TL may consist of a plurality of lines, and may include, for example, a serial clock line SCL and a serial data line SDL.

Referring to FIG. 3, the first integrated circuit 200 may include an input buffer to receive data to be transmitted and a first transistor Q1. The first integrated circuit 200 may transmit a data signal inputted through the input buffer to the second integrated circuit 300 through the transmission line TL. The first integrated circuit 200 may output the data signal transmitted from the second integrated circuit 300 through the first transistor Q1.

Referring to FIG.5, the second integrated circuit 300 may include an input buffer to receive data to be transmitted and a second transistor Q2. The second integrated circuit 300 may transmit a data signal inputted through the input buffer to the first integrated circuit 200 through the transmission line TL. The second integrated circuit 300 may output the data signal transmitted from the first integrated circuit 200 through the second transistor Q2.

That is, in the interface circuit according to the embodiment of the present invention, bidirectional data transmission can be achieved freely, and the inflow of noise can be minimized by reducing the internal impedance of the transmission line TL.

As mentioned above, FIG. 2 is an equivalent circuit diagram of the constant current generating circuit according to the embodiment of the present invention. Referring to FIG. 2, the constant current generating circuit 100 may include the voltage sensing unit 110 and the constant current generation unit 120.

The voltage sensing unit 110 may include at least one transistor and resistors. The base of a transistor Q5 included in the voltage sensing unit 110 is electrically connected to a first node N1. The magnitude of a current flowing through the collector terminal of the transistor Q5 may vary according to a voltage difference Vbe between a voltage VN1 of the first node N1 and a ground voltage GND. The magnitude of the current flowing through the collector terminal may vary depending on the element characteristics of the transistor Q5. However, the magnitude of the current flowing through the collector terminal may be exponentially proportional to a ratio of the voltage difference Vbe between the voltage VN1 of the first node N1 and the ground voltage GND to a threshold voltage Vth of the transistor Q5. The sum of the current flowing through the collector terminal and the current flowing from the second node N2 to the ground plane GND corresponds to the first current I1.

The constant current generation unit 120 may include a plurality of transistors Q3 and Q4. The base terminals of the third transistor Q3 and the fourth transistor Q4 are in contact with each other. The emitter terminals of the third transistor Q3 and the fourth transistor Q4 may be connected to a first power supply voltage V_{CC} through resistors R1 and R2, respectively. Corresponding to the magnitude of the first current flowing through a first flow path P1, the second current I2 of the same magnitude as the first current I1 may flow through a second flow path P2, and the second current I2 may be provided to the transmission line TL.

As mentioned above, FIG. 3 is an equivalent circuit diagram of the integrated circuit according to the embodiment of the present invention. Referring to FIG. 3, the first integrated circuit 200 includes an input buffer to receive data to be transmitted and a first transistor Q1. The first integrated circuit 200 may transmit a data signal inputted through the input buffer to the second integrated circuit 300 through the transmission line TL. The first integrated circuit 200 may output the data signal transmitted from the second integrated circuit 300 through the first transistor Q1.

FIG. 3 illustrates an equivalent circuit of the integrated circuit, but it is not limited thereto. The first integrated circuit 200 and the second integrated circuit 300 may be replaced by using an open collector output circuit or open drain output circuit.

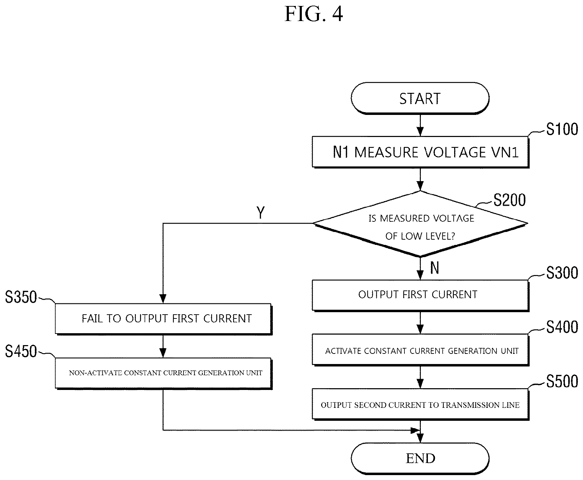

FIG. 4 is a flowchart showing an operation of the interface circuit according to the embodiment of the present invention.

Referring to FIGS. 3 and 4, in the interface circuit, a signal of a high or low level may be applied to the first integrated circuit 200. If a signal of a low level is applied to the first integrated circuit 200, the first transistor Q1 is turned on, and the transmission line TL may be electrically connected to the ground plane GND. That is, if a signal of a low level is applied to the first integrated circuit 200, the impedance of the transmission line TL approaches zero and the inflow of noise becomes difficult. If a signal of a high level is applied to the first integrated circuit 200, the first transistor Q1 is turned off, and the signal of high level may be applied to the transmission line TL.

Referring to FIG. 4, first, the voltage sensing unit 110 of the constant current generating circuit 100 may measure the voltage VN1 of the first node formed on the transmission line TL (step S100). The voltage sensing unit 110 determines whether the measured voltage VN1 of the first node is of a low level (step S200). If the voltage VN1 of the first node measured by the voltage sensing unit 110 is of a low level, it is impossible to output the first current I1 (step S350). Since the first current I1 is not outputted, the constant current generation unit 120 cannot be activated (step S450), and the current cannot be supplied to the transmission line TL. On the other hand, if the voltage VN1 of the first node measured by the voltage sensing unit 110 is of a high level, the voltage sensing unit 110 outputs the first current I1 (step S300). The first current I1 flows through the first flow path P1, and the constant current generation unit 120 is activated by the first current I1 (step S400). The second current I2 corresponding to the first current I1 may be outputted to the transmission line TL (step S500).

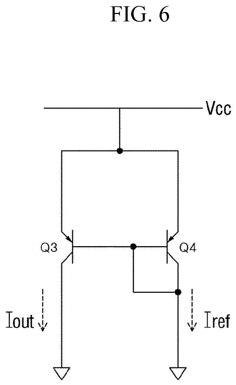

As mentioned above, FIG. 5 is an equivalent circuit diagram of the integrated circuit according to the first embodiment of the present invention. In addition, FIG. 6 is an equivalent circuit diagram of a current mirror according to the first embodiment of the present invention.

Referring to FIG. 5, the interface circuit may include the constant current generating circuit 100, the first integrated circuit 200 and the second integrated circuit 300.

The constant current generating circuit 100 may include the voltage sensing unit 110 including the transistor Q5 and a plurality of resistors R3, R4 and R5, and the constant current generation unit 120 may include the third transistor Q3 and the fourth transistor Q4.

The base of the transistor Q5 of the voltage sensing unit 110 is electrically connected to the first node N1 through resistor R5. The magnitude of the current flowing through the collector terminal of the transistor Q5 may vary according to the voltage difference Vbe between the voltage VN1 of the first node N1 and the ground voltage GND. The magnitude of the current flowing through the collector terminal may vary depending on the element characteristics of the transistor Q5. However, the magnitude of the current flowing through the collector terminal may be exponentially proportional to a ratio of the voltage difference Vbe between the voltage VN1 of the first node N1 and the ground voltage GND to the threshold voltage Vth of the transistor Q5. The sum of the current flowing through the collector terminal and the current flowing from a second node N2 to the ground plane GND corresponds to the first current I1.

The constant current generation unit 120 may include a plurality of transistors Q3 and Q4. The base terminals of the third transistor Q3 and the fourth transistor Q4 are in contact with each other. The emitter terminals of the third transistor Q3 and the fourth transistor Q4 may be connected to the first power supply voltage V_{CC} through resistors R1 and R2, respectively. Corresponding to the magnitude of the first current flowing through the first flow path P1, the second current I2 of the same magnitude as the first current I1 may flow through the second flow path P2, and the second current I2 may be provided to the transmission line TL. The current mirror formed by the third transistor Q3 and the fourth transistor Q4 will be described in detail with reference to FIG. 6.

FIG. 6 shows a pnp current mirror. In the pnp current mirror, both the emitter terminal of the first transistor Q3 and the emitter terminal of the second transistor Q4 are connected to the power supply voltage V_{CC}. The base terminal and the collector terminal of the second transistor Q4 are coupled to each other.

A reference current Iref is applied to the collector terminal of the second transistor Q4, and an output current lout flows through the first transistor Q3. If the characteristics of the second transistor Q4 are the same as those of the first transistor Q3, i.e., if the characteristics of the transistors depending on the standards (e.g., a width, a length and the like) of the transistors are identical, the output current lout is equal to the reference current Iref. In FIG. 5, a plurality of resistors R1 and R2 are coupled to the emitter terminals of the current mirror, but the resistors R1 and R2 coupled to the emitter terminals of the current mirror may be omitted.

Returning to the description of FIG. 5, the first integrated circuit 200 may include an input buffer 210 to receive the data to be transmitted, and the first transistor Q1. A data signal SL/H which is inputted through the input buffer 210 may be transmitted to the second integrated circuit 300 through the transmission line TL. The first integrated circuit 200 may serve as a master or slave in an I2C interface circuit.

The second integrated circuit 300 may include an input buffer 310 to receive the data to be transmitted, and the second transistor Q2. A data signal which is inputted through the input buffer 310 may be transmitted to the first integrated circuit 200 through the transmission line TL. The data signal transmitted from the first integrated circuit 200 may be outputted through the second transistor Q2.

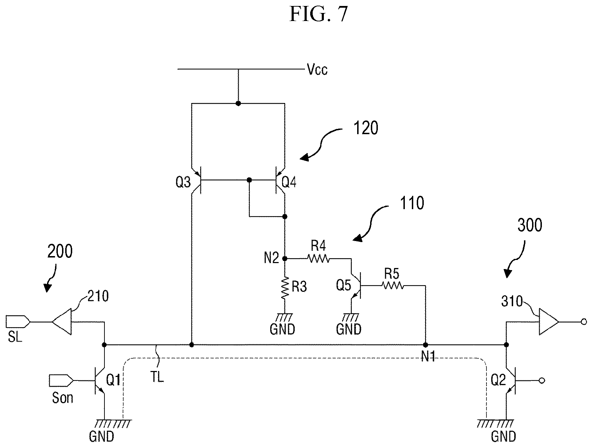

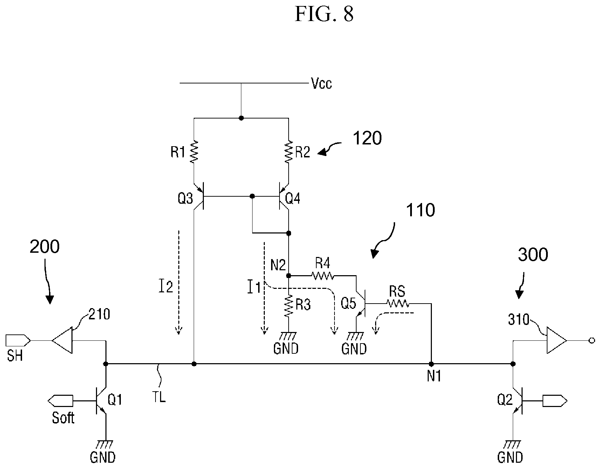

FIG. 7 is a circuit diagram illustrating characteristics when the interface circuit according to the first embodiment of the present invention operates at a low level. FIG. 8 is a circuit diagram illustrating characteristics when the interface circuit according to the first embodiment of the present invention operates at a high level.

Referring to FIG. 7, if a signal SL of a low level is inputted to an input terminal of the first integrated circuit 200, the signal SL of low level may be applied to the transmission line TL through the input buffer 210. Further, if the signal SL of low level is inputted, the first transistor Q1 of the first integrated circuit 200 or the second transistor Q2 of the second integrated circuit 300 is switched on, and the transmission line TL may be electrically connected to the ground plane. That is, the impedance of the transmission line TL viewed from the outside approaches zero, and the inflow of noise may hardly occur.

Further, if the signal SL of low level is inputted to the transmission line TL, the fifth transistor Q5 of the voltage sensing unit 110 cannot be turned on, and a low current can flow only through the third resistor R3. That is, since the fifth transistor Q5 for varying the magnitude of the current of the constant current generating circuit 100 cannot operate by the signal SL of low level, it is possible to reduce the amount of the current outputted from the constant current generating circuit 100 and the power consumption can be reduced by reducing an unnecessary current.

Referring to FIG. 8, if a signal SH of a high level is inputted to the input terminal of the first integrated circuit 200, the signal SL of high level may be applied to the transmission line TL through the input buffer 210. Further, if the signal SH of high level is applied, the first transistor Q1 or the second transistor Q2 may be switched off. If the signal SH of high level is applied, the inflow of noise is likely to occur due to a pull-up resistor or the internal resistance of the transmission line TL. In order to prevent the inflow of noise, the constant current generating circuit 100 may reduce the impedance of the transmission line TL by supplying the current.

First, the fifth transistor Q5 of the voltage sensing unit 110 is turned on in response to the voltage VN1 of the first node N1, and a current I11 corresponding to the voltage VN1 of the first node N1 may flow through the collector terminal of the fifth transistor Q5. A voltage drop occurs in the fourth resistor R4 by the current I11 corresponding to the voltage VN1 of the first node N1. A voltage VN2 of the second node N2 increases by the voltage drop. A current I11 corresponding to the voltage VN2 of the second node N2 may flow through the third resistor R3. The first current is the sum of the current I11 corresponding to the voltage VN2 of the second node N2 in the third resistor R3 and the current I12 corresponding to the voltage VN1 of the first node N1. That is, the magnitude of the first current I1 when the signal SH of high level is applied is larger than the magnitude of the first current I1 when the signal SL of low level is applied.

The constant current generation unit 120 may output the second current I2 having the same magnitude as the first current I1, and the second current I2 is provided to the transmission line TL. Since the transmission line TL may include the internal impedance and parasitic capacitance, as the length of the transmission line TL increases, the internal impedance increases, and a time constant τ increases. As the time constant τ increases, an RC delay may occur to decrease the rising speed or falling speed of the input signal. That is, the constant current generating circuit 100 provides the current to the transmission line TL, and there is an effect of reducing the impedance of the transmission line TL, which reduces the time constant τ. Thus, the RC delay is reduced and the interface circuit may operate at a high speed.

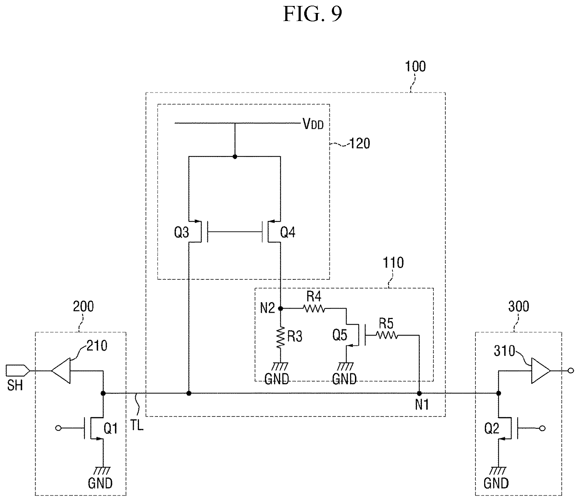

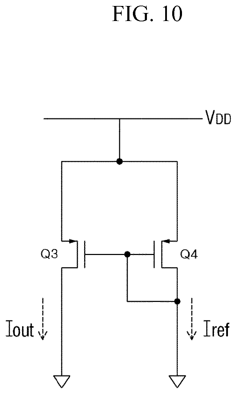

FIG. 9 is an equivalent circuit diagram of an interface circuit according to a second embodiment of the present invention. FIG. 10 is an equivalent circuit diagram of a current mirror according to the second embodiment of the present invention.

In the interface circuit of FIGS. 9 and 10, a bipolar junction transistor (BJT) in the interface circuit of FIGS. 5 and 6 is replaced by a metal-oxide-semiconductor field-effect transistor (hereinafter, referred to as 'MOSFET'). Since the bipolar junction transistor (BJT) and the MOSFET have similar operating principles, the operating characteristics of the interface circuit of FIGS. 9 and 10 are similar to the operating characteristics of the interface circuit of FIGS. 5 and 6 and, thus, a repeated description will be omitted.

Referring to FIG. 9, the interface circuit may include the constant current generating circuit 100, the first integrated circuit 200, and the second integrated circuit 300.

The constant current generating circuit 100 may include the voltage sensing unit 110 and the constant current generation unit 120.

The gate terminal of the fifth transistor Q5 of the voltage sensing unit 110 is electrically connected to the first node N1 through resistor R5. The magnitude of the current flowing through the drain terminal of the transistor Q5 may vary according to a voltage difference Vgs between the voltage VN1 of the first node N1 and the ground voltage GND. The magnitude of the current flowing through the drain terminal may vary depending on the element characteristics of the transistor Q5. However, the magnitude of the current flowing through the drain terminal may be exponentially proportional to a ratio of the voltage difference Vgs between the voltage VN1 of the first node N1 and the ground voltage GND to the threshold voltage Vth of the transistor Q5. The sum of the current flowing through the drain terminal and the current flowing from the second node N2 to the ground plane GND corresponds to the first current I1.

The constant current generation unit 120 may include a plurality of transistors Q3 and Q4. The gate terminals of the third transistor Q3 and the fourth transistor Q4 are in contact with each other. The source terminals of the third transistor Q3 and the fourth transistor Q4 may be connected to a first power supply voltage Vdd. Corresponding to the magnitude of the first current flowing through the first flow path P1, the second current I2 of the same magnitude as the first current I1 may flow through the second flow path P2, and the second current I2 may be provided to the transmission line TL. The current mirror formed by the third transistor Q3 and the fourth transistor Q4 will be described in detail with reference to FIG. 10.

FIG. 10 shows a P type current mirror. In the P type current mirror, both the source terminal of the first transistor Q3 and the source terminal of the second transistor Q4 are connected to the power supply voltage V_{DD}. The gate terminal and the drain terminal of the second transistor Q4 are coupled to each other.

The reference current Iref is applied to the drain terminal of the second transistor Q4, and the output current lout flows through the first transistor Q3. If the characteristics of the second transistor Q4 are the same as those of the first transistor Q3, i.e., if the characteristics of the transistors depending on the standards (e.g., a width, a length and the like) of the transistors are identical, the output current lout is equal to the reference current Iref.

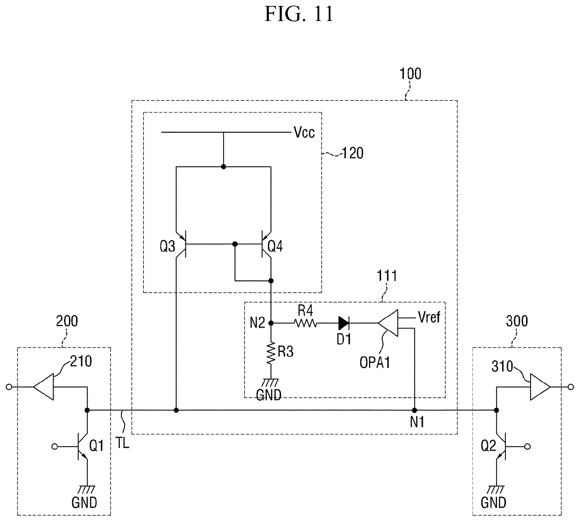

FIG. 11 is an equivalent circuit diagram of an interface circuit according to a third embodiment of the present invention.

Referring to FIG. 11, the interface circuit may include the constant current generating circuit 100, the first integrated circuit 200 and the second integrated circuit 300.

The constant current generating circuit 100 may include a voltage sensing unit 111 including a comparator OPA1 and a plurality of resistors R3 and R4, and the constant current generation unit 120 including the third transistor Q3 and the fourth transistor Q4.

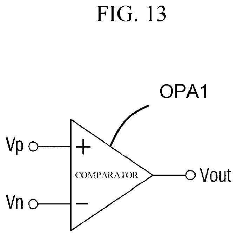

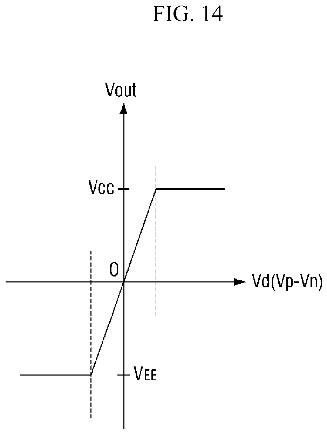

The voltage sensing unit 111 may sense the voltage of the voltage VN1 of the first node N1 by using the comparator OPA1 which compares the magnitude of the voltage VN1 of the first node N1 with the magnitude of a reference voltage Vref. The operating principle of the comparator OPA1 will be described in detail below with reference to FIGS. 13 and 14.

The constant current generation unit 120 may include a plurality of transistors Q3 and Q4. The base terminals of the third transistor Q3 and the fourth transistor Q4 are in contact with each other. The emitter terminals of the third transistor Q3 and the fourth transistor Q4 may be connected to the first power supply voltage V_{CC}. Corresponding to the magnitude of the first current I1 flowing through a first flow path P1, the second current I2 of the same magnitude as the first current I1 may flow through the second flow path P2, and the second current I2 may be provided to the transmission line TL. Since the current mirror formed by the third transistor Q3 and the fourth transistor Q4 has been described in detail above with reference to FIG. 6, a description thereof will be omitted.

Returning to the description of FIG. 11, the first integrated circuit 200 may include the input buffer 210 to receive the data to be transmitted, and the first transistor Q1. The data signal SL/H which is inputted through the input buffer 210 may be transmitted to the second integrated circuit 300 through the transmission line TL. The first integrated circuit 200 may serve as a master or slave in an I2C interface circuit.

The second integrated circuit 300 may include the input buffer 310 to receive the data to be transmitted, and the second transistor Q2. A data signal which is inputted through the input buffer 310 may be transmitted to the first integrated circuit 200 through the transmission line TL. The data signal transmitted from the first integrated circuit 200 may be outputted through the second transistor Q2.

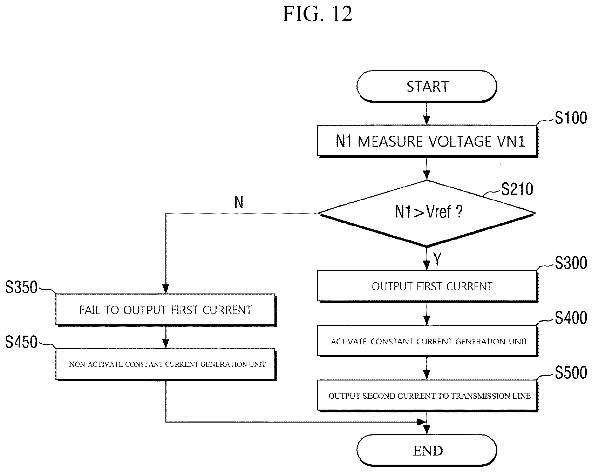

FIG. 12 is a flowchart showing an operation of the interface circuit according to the third embodiment of the present invention.

Referring to FIGS. 11 and 12, the voltage sensing unit 111 of the constant current generating circuit 100 may measure the voltage VN1 of the first node formed on the transmission line TL (step S100). The voltage sensing unit 111 compares the magnitude of the measured voltage VN1 of the first node with the magnitude of the reference voltage Vref (step S210). If the voltage VN1 of the first node measured by the voltage sensing unit 111 is lower than the reference voltage Vref, it is impossible to output the first current I1 (step S350). Since the first current I1 is not outputted, the constant current generation unit 120 cannot be activated (step S450), and the current cannot be supplied to the transmission line TL. On the other hand, if the voltage VN1 of the first node measured by the voltage sensing unit 111 is higher than the reference voltage Vref, the voltage sensing unit 111 outputs the first current I1 (step S300). The first current I1 flows through the first flow path P1, and the constant current generation unit 120 is activated by the first current I1 (step S400). The second current I2 corresponding to the first current I1 may be outputted to the transmission line TL (step S500).

However, the voltage sensing unit 111 of the interface circuit according to still another embodiment of the present invention may determine only whether the voltage VN1 of the first node is higher or lower than the reference voltage Vref, and output the first current I1 which is constant. Thus, the magnitude of the reference voltage Vref may be changed by a controller (not shown) to adjust the magnitude of the second current I2 that is supplied to the transmission line TL.

FIG. 13 is a circuit diagram showing a comparator according to the third embodiment of the present invention. FIG. 14 is a graph showing the voltage characteristics of the comparator of FIG. 13.

Referring to FIG. 13, the comparator OPA1 may compare the magnitudes of the voltages applied to a positive input terminal and a negative input terminal of an operational amplifier to output a voltage. Generally, the reference voltage Vref is applied to the positive input terminal, and a voltage to be compared is applied to the negative input terminal. The comparator OPA1 may determine whether a difference between a voltage Vp of the positive input terminal and a voltage Vn of the negative input terminal is greater than 0 or less than 0 to output a constant output voltage Vout.

Referring to FIG. 14, if a difference Vd between the voltage Vp of the positive input terminal and the voltage Vn of the negative input terminal is greater than 0, the comparator OPA1 may output a positive saturation voltage, and the positive saturation voltage may correspond to the value of the positive power supply voltage V_{CC} applied to the comparator OPA1. If the difference Vd between the voltage Vp of the positive input terminal and the voltage Vn of the negative input terminal is less than 0, the comparator OPA1 may output a negative saturation voltage, and the negative saturation voltage may correspond to the value of a negative power supply voltage V_{EE} applied to the comparator OPA1. However, if the difference Vd between the voltage Vp of the positive input terminal and the voltage Vn of the negative input terminal is less than 0, the comparator OPA1 may operate as an amplifier. In the case where the comparator OPA1 operates as an amplifier, the voltage Vout outputted with respect to the difference Vd between the voltage Vp of the positive input terminal and the voltage Vn of the negative input terminal may be increased linearly.

That is, the first current I1 which is variable may flow through the voltage sensing unit 111 of FIG. 11 during a section in which the comparator OPA1 operates as an amplifier.

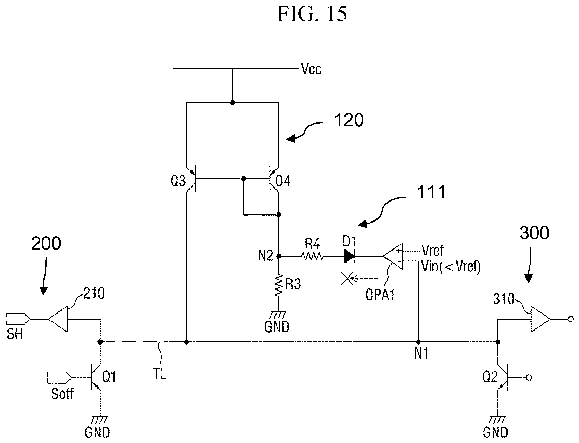

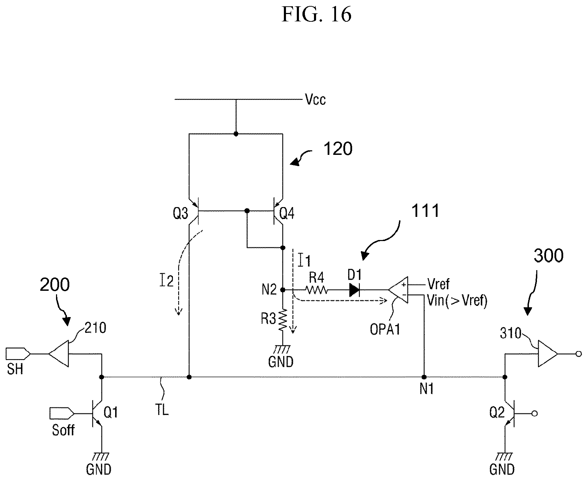

FIGS. 15 and 16 are circuit diagrams illustrating characteristics when the interface circuit according to the third embodiment of the present invention operates at a high level.

Referring to FIG. 15, if a signal SH of a high level is inputted to the input terminal of the first integrated circuit 200, the signal SH of high level may be applied to the transmission line TL through the input buffer 210. Further, if the signal SH of high level is applied, the first transistor Q1 of the first integrated circuit 200 or the second transistor Q2 of the second integrated circuit 300 may be switched off. If the signal SH of high level is applied, the inflow of noise is likely to occur due to a pull-up resistor or the internal resistance of the transmission line TL. In order to prevent the inflow of noise, the constant current generating circuit 100 may reduce the impedance of the transmission line TL by supplying the current.

First, the voltage sensing unit 111 of the constant current generating circuit 100 may measure the voltage VN1 of the first node N1 formed on the transmission line TL. The voltage sensing unit 111 compares the magnitude of the measured voltage VN1 of the first node N1 with the magnitude of the reference voltage Vref. If the voltage VN1 of the first node N1 measured by the voltage sensing unit 111 is lower than the reference voltage Vref, the comparator OPA1 outputs the negative power supply voltage V_{EE} (shown in FIG. 14). The output terminal of the comparator OPA1 may be connected to the cathode electrode of a first diode D1. Since a current can flow in a direction from the anode electrode to the cathode electrode of the first diode D1, the voltage of the anode electrode is required to be higher than the voltage of the cathode electrode in order to flow the current. The anode electrode of the first diode D1 is connected to the second node N2 via resistor R4, and the cathode electrode of the first diode D1 may be connected to the output terminal of the comparator OPA1. In FIG. 15, since the reference voltage Vref is applied to the positive input terminal of the comparator OPA1 and the voltage VN1 of the first node is applied to the negative input terminal of the comparator OPA1, the magnitude of the voltage applied to the positive input terminal is larger than the magnitude of the voltage applied to the negative input terminal, and a positive saturation voltage is outputted. Since the output voltage of the comparator OPA1 is higher than the voltage of the second node N2, a current cannot flow through the fourth resistor R4 by the first diode, and a small amount of current flows through only the third resistor R3.

That is, if the voltage VN1 of the first node is lower than the reference voltage Vref, the constant current generation unit 120 may output a small amount of current to the transmission line TL, thereby reducing the power consumption consumed by the constant current generating circuit.

Referring to FIG. 16, if the voltage VN1 of the first node N1 measured by the voltage sensing unit 111 is higher than the reference voltage Vref, the comparator OPA1 outputs the positive power supply voltage V_{CC} (shown in FIG. 14). The output terminal of the comparator OPA1 may be connected to the cathode electrode of the first diode D1. Since the reference voltage Vref is applied to the positive input terminal of the comparator OPA1 and the voltage VN1 of the first node is applied to the negative input terminal of the comparator OPA1, the magnitude of the voltage applied to the positive input terminal is smaller than the magnitude of the voltage applied to the negative input terminal, and a negative saturation voltage is outputted. Since the output voltage of the comparator OPA1 is lower than the voltage of the second node N2, the current I12 may flow through the first diode. A voltage drop occurs in the fourth resistor R4 by the current I12 corresponding to the voltage VN1 of the first node N1. The voltage VN2 of the second node N2 increases by the voltage drop. The current I11 corresponding to the voltage VN2 of the second node N2 may also flow through the third resistor R3. The first current I1 is the sum of the current I11 corresponding to the voltage VN2 of the second node N2 in the third resistor R3 and the current I12 corresponding to the voltage VN1 of the first node N1. That is, the magnitude of the first current I1 when the signal SH of high level is applied is larger than the magnitude of the first current I1 when the signal SL of low level is applied.

The constant current generation unit 120 may output the second current I2 having the same magnitude as the first current I1, and the second current I2 is provided to the transmission line TL. There is an effect of reducing the impedance of the transmission line TL, which reduces the time constant τ. Thus, the RC delay is reduced and the interface circuit may operate at a high speed.

The interface circuit using the bipolar junction transistors (BJT) has been illustrated in FIGS. 15 and 16, but it is not limited thereto. The first to fourth transistors Q1 to Q4, respectively, may be replaced by MOSFETs.

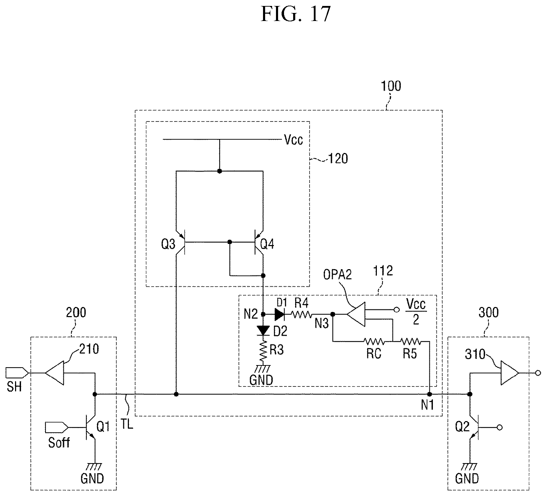

FIG. 17 is an equivalent circuit diagram of an interface circuit according to a fourth embodiment of the present invention.

Referring to FIG. 17, the interface circuit may include the constant current generating circuit 100, the first integrated circuit 200 and the second integrated circuit 300.

The constant current generating circuit 100 may include a voltage sensing unit 112 including a differential amplifier OPA2 and a plurality of resistors R3, R4, R5 and R_{C}, and the constant current generation unit 120 including the third transistor Q3 and the fourth transistor Q4.

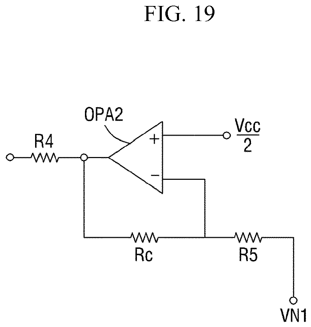

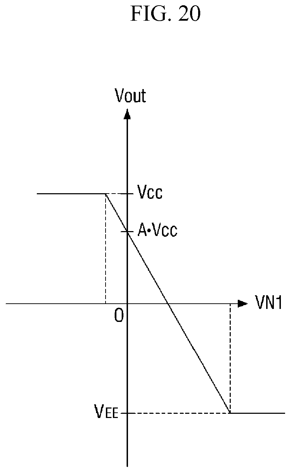

The voltage sensing unit 112 may sense the voltage of the voltage VN1 of the first node N1 by using the differential amplifier OPA2 which can continuously output a voltage by voltage division of a voltage V_{CC}/2 applied to the positive input terminal of the operational amplifier, the voltage of the output terminal of the operational amplifier, and the voltage VN1 of the first node N1. The operating principle of the differential amplifier OPA2 will be described in detail below with reference to FIGS. 19 and 20.

The constant current generation unit 120 may include a plurality of transistors Q3 and Q4. The base terminals of the third transistor Q3 and the fourth transistor Q4 are in contact with each other. The emitter terminals of the third transistor Q3 and the fourth transistor Q4 may be connected to the first power supply voltage V_{CC}. Corresponding to the magnitude of the first current flowing through the first flow path P1, the second current I2 of the same magnitude as the first current I1 may flow through the second flow path P2, and the second current I2 may be provided to the transmission line TL. Since the current mirror formed by the third transistor Q3 and the fourth transistor Q4 has been described in detail with reference to FIG. 6, a description thereof will be omitted.

The first integrated circuit 200 may include the input buffer 210 to receive the data to be transmitted, and the first transistor Q1. The data signal SL/H which is inputted through the input buffer 210 may be transmitted to the second integrated circuit 300 through the transmission line TL.

The second integrated circuit 300 may include the input buffer 310 to receive the data to be transmitted, and the second transistor Q2. The data signal which is inputted through the input buffer 310 may be transmitted to the first integrated circuit 200 through the transmission line TL. The data signal transmitted from the first integrated circuit 200 may be outputted through the second transistor Q2.

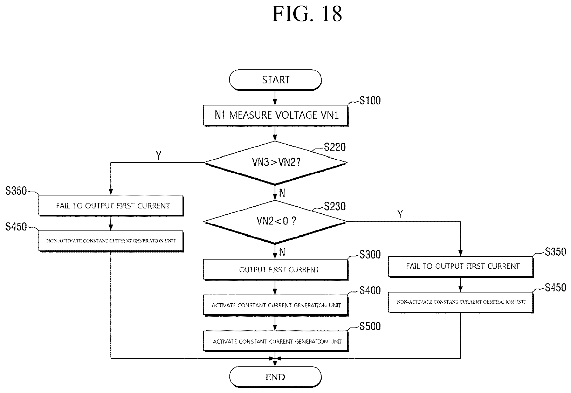

FIG. 18 is a flowchart showing an operation of the interface circuit according to the fourth embodiment of the present invention.

Referring to FIGS. 17 and 18, the voltage sensing unit 112 of the constant current generating circuit 100 may measure the voltage VN1 of the first node formed on the transmission line TL (step S100). The voltage sensing unit 112 compares the magnitude of the voltage VN2 of the second node N2 with the magnitude of a voltage VN3 of a third node N3 (step S220). If the magnitude of the voltage VN2 of the second node N2 is lower than the magnitude of the voltage VN3 of the third node N3, since a current cannot flow through the fourth resistor R4 due to the first diode D1, it is impossible to output the first current I1 (step S350). Since the first current I1 is not outputted, the constant current generation unit 120 cannot be activated (step S450), and the current cannot be supplied to the transmission line TL.

On the other hand, if the magnitude of the voltage VN2 of the second node N2 is higher than the magnitude of the voltage VN3 of the third node N3, the voltage sensing unit 112 determines whether the voltage VN2 of the second node N2 is higher than the voltage (0V) of the ground plane (step S230). If the voltage VN2 of the second node N2 is lower than the voltage (0V) of the ground plane, since a current cannot flow through the third resistor R3 due to a second diode D2, it is impossible to output the first current I1 (step S350). Since the first current I1 is not outputted, the constant current generation unit 120 cannot be activated (step S450), and the current cannot be supplied to the transmission line TL.

If the voltage VN2 of the second node N2 is higher than the voltage (0V) of the ground plane, since the first current I1 can flow into the third resistor R3, the first current I1 flows through the first flow path P1. The constant current generation unit 120 is activated by the first current I1 (step S400), and the second current I2 corresponding to the first current I1 can be supplied to the transmission line TL (step S500).

FIG. 19 is an equivalent circuit diagram of the voltage sensing unit according to the fourth embodiment of the present invention. FIG. 20 is a graph showing the voltage characteristics of FIG. 19.

Referring to FIGS. 17 and 19, the differential amplifier OPA2 may adjust the magnitude of the current flowing through the variable resistor R_{C} by adjusting the magnitude of the resistance of the variable resistor R_{C} on the assumption that the magnitude of the voltage applied to the positive input terminal of the operational amplifier is the same as the magnitude of the voltage applied to the negative input terminal of the operational amplifier. The voltage Vout of the output terminal can be determined by the amount of current flowing through the variable resistor R_{C}. Thus, it is possible to adjust the magnitude of the current I12 flowing between the second node N2 and the output terminal of the operational amplifier. Since the variable resistor R_{C} is connected to the negative input terminal of the operational amplifier, the differential amplifier OPA2 may provide an inverted voltage to the output terminal. The differential amplifier OPA2 may linearly adjust the magnitude of the first current I1 by linearly generating the output voltage with respect to the input voltage. Hereinafter, the voltage characteristics of the differential amplifier OPA2 will be described in detail with reference to FIG. 20.

Referring to FIGS. 17 and 20, the differential amplifier OPA2 serves as an inverting amplifier since the voltage obtained by voltage division of the variable resistor R_{C} is applied to the negative input terminal. That is, as the voltage VN1 of the first node N1 increases, the output voltage Vout of the differential amplifier decreases. A ratio A of the output voltage Vout of the differential amplifier to the voltage VN1 of the first node N1 may vary depending on the magnitudes of the resistances of the variable resistor R_{C} and the fifth resistor R5.

Further, since the output voltage of the operational amplifier cannot exceed the voltage applied to the operational amplifier according to the characteristics of the operational amplifier, the differential amplifier OPA2 may linearly provide the output voltage Vout between the positive saturation voltage and the negative saturation voltage.

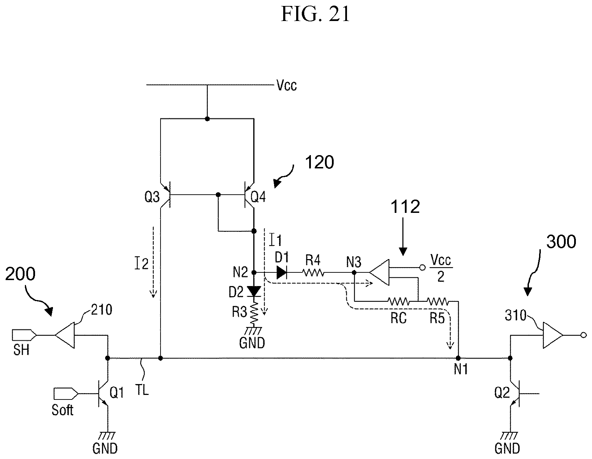

FIG. 21 is a circuit diagram showing the characteristics when the interface circuit according to the fourth embodiment of the present invention operates at a high level.

Referring to FIG. 21, if the signal SH of high level is inputted to the input terminal of the first integrated circuit 200, the signal SL of high level may be applied to the transmission line TL through the input buffer 210. Further, if the signal SH of high level is applied, the first transistor Q1 of the first integrated circuit 200 or the second transistor Q2 of the second integrated circuit 300 may be switched off. If the signal SH of high level is applied, the inflow of noise is likely to occur due to a pull-up resistor or the internal resistance of the transmission line TL. In order to prevent the inflow of noise, the constant current generating circuit 100 may reduce the impedance of the transmission line TL by supplying the current.

First, the voltage sensing unit 112 of the constant current generating circuit 100 may measure the voltage VN1 of the first node N1 formed on the transmission line TL. Since the voltages applied to the positive input terminal and the negative input terminal of the differential amplifier OPA2 of the voltage sensing unit 112 are almost the same, the current corresponding to a difference between the voltage VN1 of the first node N1 and the voltage V_{CC}/2 applied to the negative input terminal flows through the fifth resistor R5. Since the same current as the current flowing through the fifth resistor R5 flows through the variable resistor R_{C} (current cannot flow through the input terminal of an ideal operational amplifier), the voltage of the third node N3 may vary linearly in accordance with the positive input voltage V_{CC}/2 of the differential amplifier OPA2.

If the voltage of the third node N3 is lower than the voltage of the second node N2, the current I12 can flow in the fourth resistor R4 through the first diode. If the voltage of the third node N3 is higher than the voltage of the second node N2, the current I12 cannot flow in the fourth resistor R4 due to the first diode D1. As the amount of current flowing through the fourth resistor R4 increases, the magnitude of the first current I1 increases, and the amount of current outputted to the transmission line TL from the constant current generation unit 120 increases. Thus, it is possible to reduce the internal impedance of the transmission line TL, thereby reducing the inflow of noise.

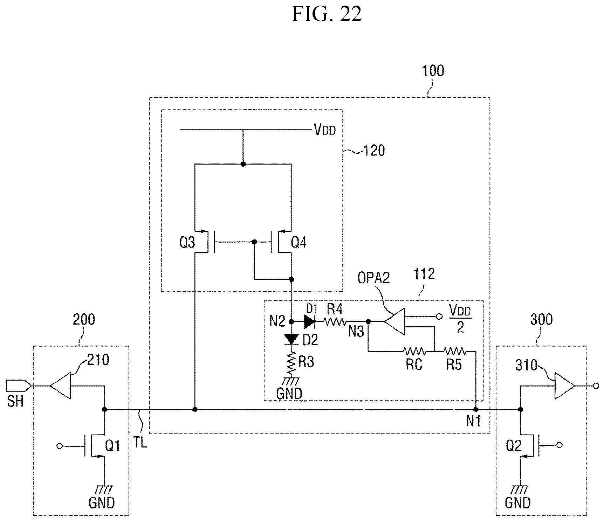

FIG. 22 is an equivalent circuit diagram of an interface circuit according to a fifth embodiment of the present invention.

In the interface circuit of FIG. 22, the bipolar junction transistors (BJT) in the interface circuit of FIG. 18 are replaced by MOSFETs. Since the operating principle of the bipolar junction transistor (BJT) is similar to the operating principle of the MOSFET, the operating characteristics of the interface circuit of FIG. 22 are similar to the operating characteristics of the interface circuit of FIG. 18, and a repeated description will be omitted.

Referring to FIG. 22, the interface circuit may include the constant current generating circuit 100, the first integrated circuit 200 and the second integrated circuit 300.

The constant current generating circuit 100 may include the voltage sensing unit 112 and the constant current generation unit 120. The constant current generation unit 120 may include a plurality of transistors Q3 and Q4. The gate terminals of the third transistor Q3 and the fourth transistor Q4 are in contact with each other. The source terminals of the third transistor Q3 and the fourth transistor Q4 may be connected to the first power supply voltage V_{DD}. Corresponding to the magnitude of the first current flowing through the first flow path P1, the second current I2 of the same magnitude as the first current I1 may flow through the second flow path P2, and the second current I2 may be provided to the transmission line TL. The current mirror formed by the third transistor Q3 and the fourth transistor Q4 has been described in detail with reference to FIG. 10.

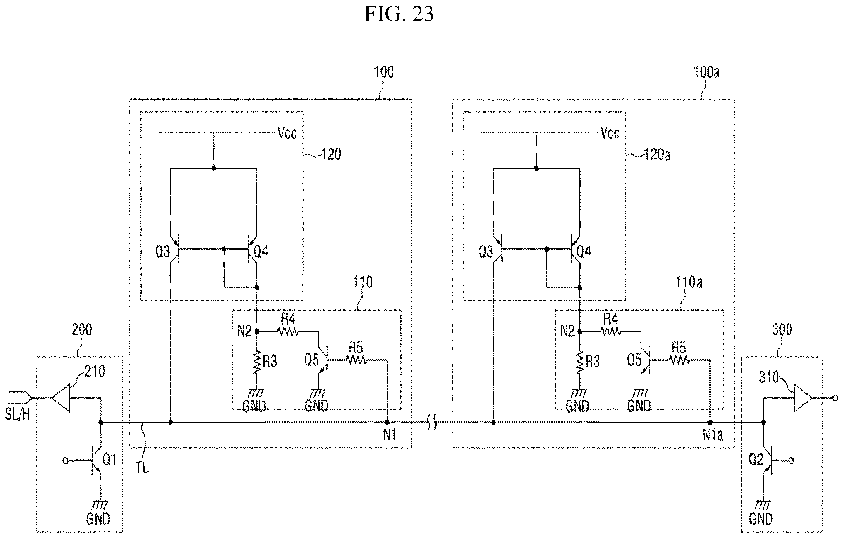

FIGS. 23 to 29 are equivalent circuit diagrams of integrated circuits according to some other embodiments of the present invention.

FIG. 23 is a circuit diagram showing a constant current generating circuit connected to both ends of the interface circuit according to one embodiment of the present invention. The circuit of FIG. 23 is similar to the interface circuit of FIG. 5, but is different from the interface circuit of FIG. 5 in that a constant current generating circuit 100a is additionally connected to the transmission line TL adjacent to the second integrated circuit 300. As the transmission line TL is longer, the internal impedance of the transmission line TL increases. Thus, by adding the constant current generating circuit 100a, it is possible to reduce the impedance of the transmission line TL viewed from the outside of the transmission line TL.

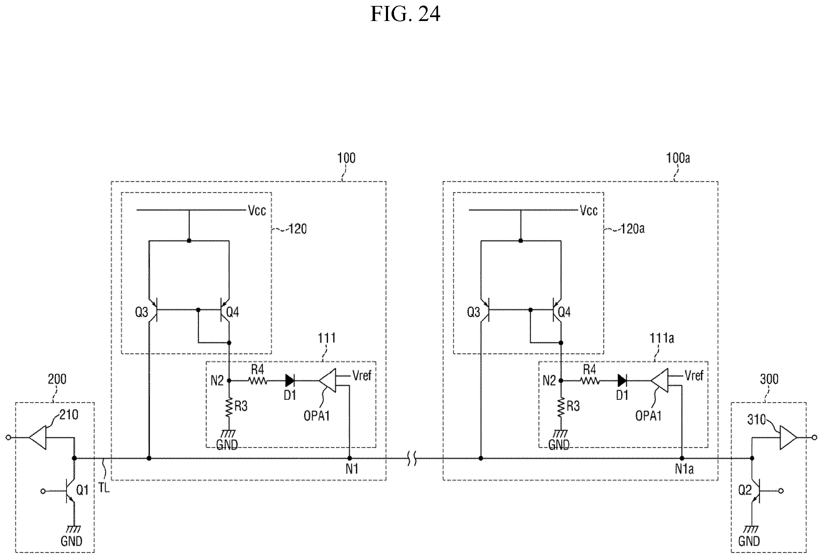

FIG. 24 is a circuit diagram showing a constant current generating circuit connected to both ends of the interface circuit according to another embodiment of the present invention. The circuit of FIG. 24 is similar to the interface circuit of FIG. 11, but is different from the interface circuit of FIG. 11 in that a constant current generating circuit 100a is additionally connected to the transmission line TL adjacent to the second integrated circuit 300. As the transmission line TL is longer, the internal impedance of the transmission line TL increases. Thus, by adding the constant current generating circuit 100a, it is possible to reduce the impedance of the transmission line TL viewed from the outside of the transmission line TL.

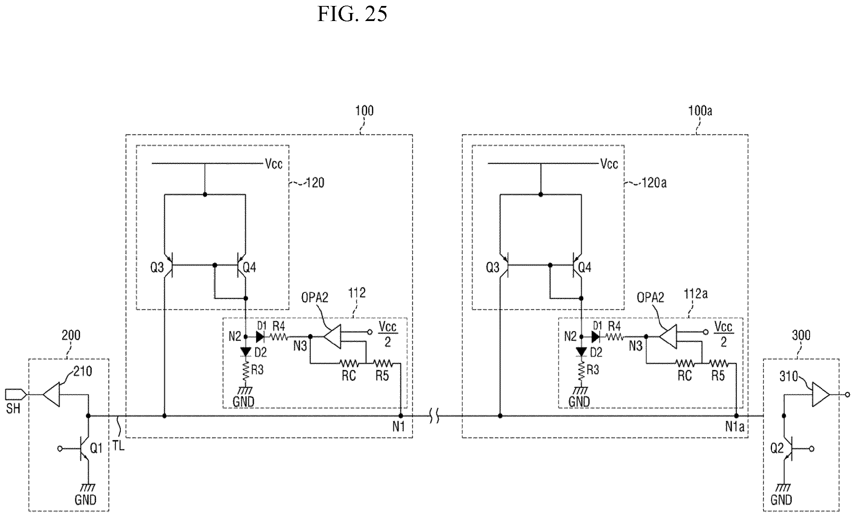

FIG. 25 is a circuit diagram showing a constant current generating circuit connected to both ends of the interface circuit according to still another embodiment of the present invention. The circuit of FIG. 25 is similar to the interface circuit of FIG. 17, but is different from the interface circuit of FIG. 17 in that a constant current generating circuit 100a is additionally connected to the transmission line TL adjacent to the second integrated circuit 300. As the transmission line TL is longer, the internal impedance of the transmission line TL increases. Thus, by adding the constant current generating circuit 100a, it is possible to reduce the impedance of the transmission line TL viewed from the outside of the transmission line TL.

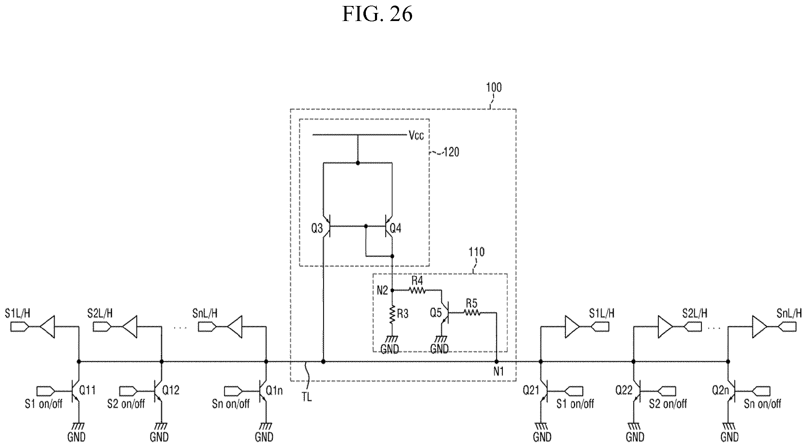

FIG. 26 shows a multi-connection circuit between a plurality of first integrated circuits and a plurality of second integrated circuits. By adding the constant current generating circuit 100 to the transmission line TL in the connection between a plurality of master circuits and a plurality of slave circuits, it is possible to reduce the inflow of noise. The circuit of FIG. 26 is similar to the interface circuit of FIG. 5, but there is a difference in that n master circuits and n slave circuits are connected by the transmission line TL. Although a plurality of circuits are connected by the transmission line TL, by providing the address of the operated circuit through the transmission line TL, the multi-connection circuit can also be operated in the same manner as the interface circuit of FIG. 5. FIG. 26 illustrates a connection between n master circuits and n slave circuits, but it is not limited thereto. A connection between one master circuit and a plurality of slave circuits is also applicable.

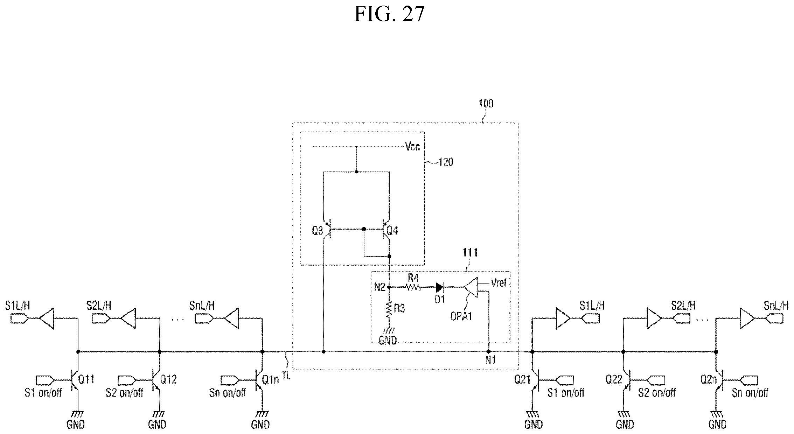

FIG. 27 shows a multi-connection circuit between a plurality of first integrated circuits and a plurality of second integrated circuits. By adding the constant current generating circuit 100 to the transmission line TL in the connection between a plurality of master circuits and a plurality of slave circuits, it is possible to reduce the inflow of noise. The circuit of FIG. 27 is similar to the interface circuit of FIG. 11, but there is a difference in that n master circuits and n slave circuits are connected by the transmission line TL. FIG. 27 illustrates a connection between n master circuits and n slave circuits, but it is not limited thereto. A connection between one master circuit and a plurality of slave circuits is also applicable.

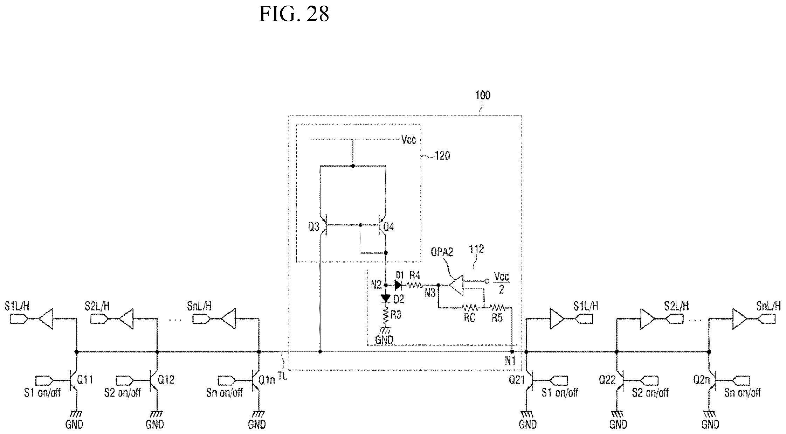

FIG. 28 shows a multi-connection circuit between a plurality of first integrated circuits and a plurality of second integrated circuits. By adding the constant current generating circuit 100 to the transmission line TL in the connection between a plurality of master circuits and a plurality of slave circuits, it is possible to reduce the inflow of noise. The circuit of FIG. 28 is similar to the interface circuit of FIG. 17, but there is a difference in that n master circuits and n slave circuits are connected by the transmission line TL. FIG. 28 illustrates a connection between n master circuits and n slave circuits, but it is not limited thereto. A connection between one master circuit and a plurality of slave circuits is also applicable.

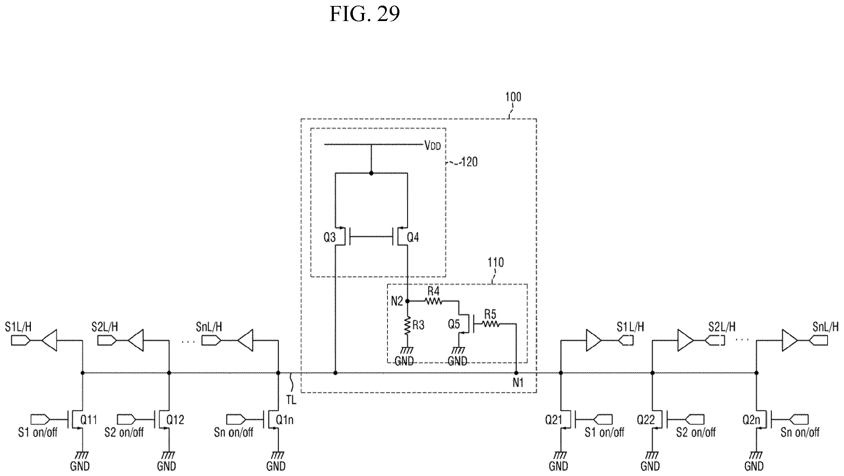

In an interface circuit of FIG. 29, the bipolar junction transistors (BJT) in the interface circuit of FIG. 26 are replaced by MOSFETs. Since the operating principle of the bipolar junction transistor (BJT) is similar to the operating principle of the MOSFET, the operating characteristics of the interface circuit of FIG. 29 are similar to the operating characteristics of the interface circuit of FIG. 26. Also in the interface circuits of FIGS. 27 and 28, the bipolar junction transistors (BJT) may be replaced by MOSFETs.

However, the effects of the present invention are not restricted to the ones set forth herein. The above and other effects of the present invention will become more apparent to one of ordinary skill in the art to which the present invention pertains by referencing the claims.

While the present invention has been particularly shown and described with reference to exemplary embodiments thereof, it will be understood by those of ordinary skill in the art that various changes in form and detail may be made therein without departing from the scope of the present invention as defined by the following claims. It is therefore desired that the present embodiments be considered in all respects as illustrative and not restrictive, reference being made to the appended claims rather than the foregoing description to indicate the scope of the invention.

## Claims

1. An interface circuit, comprising:
a first integrated circuit (200) to transmit or receive data;
a second integrated circuit (300) connected to the first integrated circuit by a transmission line (TL) to transmit or receive data; and
a constant current generating circuit (100;100a) connected to the transmission line (TL) to output a current of a constant magnitude to the transmission line (TL);
wherein the constant current generating circuit (100;100a) is adapted to adjust the current outputted to the transmission line (TL) by sensing a voltage of the transmission line; and
wherein the constant current generating circuit (100;100a) comprises:
a voltage sensing unit (110;111;112) which is adapted to sense the voltage of the transmission line (VN1) so as to generate a first current (II) corresponding to the sensed voltage of the transmission line (VN1), and
a constant current generation unit (120) which is adapted to output a current corresponding to the first current (I1);
the said interface circuit being **characterized in that**;
the constant current generation unit (120) comprises a plurality of transistors (Q1, Q2, Q3, Q4); and
the constant current generation unit (120) comprises a current mirror for outputting to the transmission line (TL) a second current (12) corresponding to the first current (I1).

2. An interface circuit according to claim 1, wherein the voltage sensing unit (110;111;112) comprises at least one sensing transistor; and
wherein said at least one sensing transistor is adapted to be turned on in response to the voltage of the transmission line (VN1) and generates the first current (II) corresponding to the voltage of the transmission line (VN1).

3. An interface circuit according to claim 2, wherein each said at least one sensing transistor and each of the plurality of transistors (Q1, Q2, Q3, Q4) is formed of a bipolar transistor.

4. An interface circuit according to claim 2, wherein each said at least one sensing transistor and each of the plurality of transistors (Q1, Q2, Q3, Q4) is formed of a field effect transistor.

5. An interface circuit according to claim 1, wherein the voltage sensing unit comprises a comparator (OPA1) and a first diode (D1); and
wherein the comparator (OPA1) is adapted to compare the voltage of the transmission line (VN1) with a reference voltage (Vref) so as to output a predetermined voltage.

6. An interface circuit according to claim 1, wherein the voltage sensing unit comprises a differential amplifier (OPA2) and a plurality of diodes (D1, D2); and
wherein the differential amplifier (OPA2) is adapted to output a voltage corresponding to the voltage of the transmission line (VN1).

7. An interface circuit according to claim 5 or 6, wherein each of the plurality of transistors (Q1, Q2, Q3, Q4) is formed of a bipolar transistor.

8. An interface circuit according to claim 5 or 6, wherein each of the plurality of transistors (Q1, Q2, Q3, Q4) is formed of a field effect transistor.

9. An interface circuit, according to any preceding claim comprising a plurality of said constant current generating circuits (100,100a).

10. An interface circuit, according to any preceding claim and comprising:
a plurality of said first integrated circuits (200); and
a plurality of said second integrated circuits (300) connected to the first integrated circuits by the transmission line (TL).

## Patentansprüche

1. Schnittstellenschaltung, umfassend:
einen ersten integrierten Schaltkreis (200), um Daten zu übertragen oder zu empfangen;
einen zweiten integrierten Schaltkreis (300), der mit dem ersten integrierten Schaltkreis durch eine Übertragungsleitung (TL) verbunden ist, um Daten zu übertragen oder zu empfangen; und
eine Konstantstromerzeugungsschaltung (100; 100a), die mit der Übertragungsleitung (TL) verbunden ist, um einen Strom einer konstanten Stärke an die Übertragungsleitung (TL) auszugeben;
worin die Konstantstromerzeugungsschaltung (100; 100a) dafür eingerichtet ist, den an die Übertragungsleitung (TL) ausgegebenen Strom durch Erfassen einer Spannung der Übertragungsleitung nachzuregeln; und
worin die Konstantstromerzeugungsschaltung (100; 100a) umfasst:
eine Spannungserfassungseinheit (110; 111; 112), die dafür eingerichtet ist, die Spannung der Übertragungsleitung (VN1) zu erfassen, um dadurch einen ersten Strom (II) zu erzeugen, welcher der erfassten Spannung der Übertragungsleitung (VN1) entspricht, und
eine Konstantstromerzeugungseinheit (120), die dafür eingerichtet ist, einen dem ersten Strom (II) entsprechenden Strom auszugeben;
wobei die Schnittstellenschaltung **dadurch gekennzeichnet ist, dass**:
die Konstantstromerzeugungseinheit (120) eine Vielzahl von Transistoren (Q1, Q2, Q3, Q4) umfasst; und
die Konstantstromerzeugungseinheit (120) einen Stromspiegel zum Ausgeben eines dem ersten Strom (II) entsprechenden zweiten Stroms (I2) an die Übertragungsleitung (TL) umfasst.

2. Schnittstellenschaltung nach Anspruch 1, worin die Spannungserfassungseinheit (110; 111; 112) mindestens einen Erfassungstransistor umfasst; und
worin der mindestens eine Erfassungstransistor dafür eingerichtet ist, als Antwort auf die Spannung der Übertragungsleitung (TL) eingeschaltet zu werden, und den der Spannung der Übertragungsleitung (VN1) entsprechenden ersten Strom (II) erzeugt.

3. Schnittstellenschaltung nach Anspruch 2, worin jeder besagte mindestens eine Erfassungstransistor und jeder aus der Vielzahl von Transistoren (Q1, Q2, Q3, Q4) aus einem bipolaren Transistor gebildet wird.

4. Schnittstellenschaltung nach Anspruch 2, worin jeder besagte mindestens eine Erfassungstransistor und jeder aus der Vielzahl von Transistoren (Q1, Q2, Q3, Q4) aus einem Feldeffekttransistor gebildet wird.

5. Schnittstellenschaltung nach Anspruch 1, worin die Spannungserfassungseinheit einen Komparator (OPA1) und eine erste Diode (D1) umfasst; und
worin der Komparator (OPA1) dafür eingerichtet ist, die Spannung der Übertragungsleitung (VN1) mit einer Referenzspannung (Vref) zu vergleichen, um dadurch eine vorbestimmte Spannung auszugeben.

6. Schnittstellenschaltung nach Anspruch 1, worin die Spannungserfassungseinheit einen Differenzverstärker (OPA2) und eine Vielzahl von Dioden (D1, D2) umfasst; und
worin der Differenzverstärker (OPA2) dafür eingerichtet ist, eine der Spannung der Übertragungsleitung (VN1) entsprechende Spannung auszugeben.

7. Schnittstellenschaltung nach Anspruch 5 oder 6, worin jeder aus der Vielzahl von Transistoren (Q1, Q2, Q3, Q4) aus einem bipolaren Transistor gebildet wird.

8. Schnittstellenschaltung nach Anspruch 5 oder 6, worin jeder aus der Vielzahl von Transistoren (Q1, Q2, Q3, Q4) aus einem Feldeffekttransistor gebildet wird.

9. Schnittstellenschaltung nach einem der vorhergehenden Ansprüche, umfassend eine Vielzahl der Konstantstromerzeugungsschaltungen (100; 100a).

10. Schnittstellenschaltung nach einem der vorhergehenden Ansprüche und umfassend:
eine Vielzahl der ersten integrierten Schaltkreise (200); und
eine Vielzahl der zweiten integrierten Schaltkreise (300), die mit den ersten integrierten Schaltkreisen durch die Übertragungsleitung (TL) verbunden sind.

## Revendications

1. Circuit d'interface, comprenant :
un premier circuit intégré (200) pour émettre ou recevoir des données ;
un second circuit intégré (300) qui est connecté au premier circuit intégré au moyen d'une ligne de transmission (TL) de manière à émettre ou recevoir des données ; et
un circuit de génération de courant constant (100 ; 100a) qui est connecté à la ligne de transmission (TL) de manière à émettre en sortie un courant d'une amplitude constante vers la ligne de transmission (TL) ;
dans lequel le circuit de génération de courant constant (100 ; 100a) est adapté de manière à régler le courant qui est émis en sortie vers la ligne de transmission (TL) en détectant une tension de la ligne de transmission ; et
dans lequel le circuit de génération de courant constant (100 ; 100a) comprend :
une unité de détection de tension (110 ; 111 ; 112) qui est adaptée de manière à détecter la tension de la ligne de transmission (VN1) de manière à générer un premier courant (II) qui correspond à la tension détectée de la ligne de transmission (VN1) ; et
une unité de génération de courant constant (120) qui est adaptée de manière à émettre en sortie un courant qui correspond au premier courant (I1) ;
ledit circuit d'interface étant **caractérisé en ce que** :
l'unité de génération de courant constant (120) comprend une pluralité de transistors (Q1, Q2, Q3, Q4) ; et
l'unité de génération de courant constant (120) comprend un miroir de courant pour une émission en sortie vers la ligne de transmission (TL) d'un second courant (I2) qui correspond au premier courant (I1).

2. Circuit d'interface selon la revendication 1, dans lequel l'unité de détection de tension (110 ; 111 ; 112) comprend au moins un transistor de détection ; et
dans lequel ledit au moins un transistor de détection est adapté de manière à être rendu passant en réponse à la tension de la ligne de transmission (VN1) et génère le premier courant (II) qui correspond à la tension de la ligne de transmission (VN1).

3. Circuit d'interface selon la revendication 2, dans lequel chaque dit au moins un transistor de détection et chacun de la pluralité de transistors (Q1, Q2, Q3, Q4) sont formés par un transistor bipolaire.

4. Circuit d'interface selon la revendication 2, dans lequel chaque dit au moins un transistor de détection et chacun de la pluralité de transistors (Q1, Q2, Q3, Q4) sont formés par un transistor à effet de champ.

5. Circuit d'interface selon la revendication 1, dans lequel l'unité de détection de tension comprend un comparateur (OPA1) et une première diode (D1) ; et
dans lequel le comparateur (OPA1) est adapté de manière à comparer la tension de la ligne de transmission (VN1) avec une tension de référence (Vref) de manière à émettre en sortie une tension prédéterminée.

6. Circuit d'interface selon la revendication 1, dans lequel l'unité de détection de tension comprend un amplificateur différentiel (OPA2) et une pluralité de diodes (D1, D2) ; et
dans lequel l'amplificateur différentiel (OPA2) est adapté de manière à émettre en sortie une tension qui correspond à la tension de la ligne de transmission (VN1).

7. Circuit d'interface selon la revendication 5 ou 6, dans lequel chacun de la pluralité de transistors (Q1, Q2, Q3, Q4) est formé par un transistor bipolaire.

8. Circuit d'interface selon la revendication 5 ou 6, dans lequel chacun de la pluralité de transistors (Q1, Q2, Q3, Q4) est formé par un transistor à effet de champ.

9. Circuit d'interface selon l'une quelconque des revendications précédentes, comprenant une pluralité desdits circuit de génération de courant constant (100, 100a).

10. Circuit d'interface selon l'une quelconque des revendications précédentes et comprenant :
une pluralité desdits premiers circuits intégrés (200) ; et
une pluralité desdits seconds circuit intégrés (300) qui sont connectés aux premiers circuits intégrés au moyen de la ligne de transmission (TL).
